# EUROPEAN PATENT SPECIFICATION

(11) **EP 1 118 835 B1**
(45) Date of publication and mention of the grant of the patent: **09.01.2002**
(21) Application number: 00105553.2
(22) Date of filing: 16.03.2000
(51) Int. Cl.: G01B 11/14, G03F 9/00

(54) **Clearance measuring device and method for exposure**
Vorrichtung zur Abstandsmessung und Verfahren zur Belichtung
Dispositif pour la mesure de l'espacement et procédé pour l'exposition

(30) Priority: 21.01.2000 JP 2000012538
(43) Date of publication of application: 25.07.2001
(73) Proprietor: SANEI GIKEN CO., LTD., Amagasaki-shi, Hyogo-ken (JP)
(72) Inventor: Miyake, Eiichi, c/o Sanei Giken Co., Ltd., Amagasaki-shi, Hyogo (JP); Miyake, Ken, c/o Sanei Giken Co., Ltd., Amagasaki-shi, Hyogo (JP)
(74) Representative: Prüfer, Lutz H., Dipl.-Phys.

(56) References cited:
- EP-A- 0 184 820
- US-A- 4 618 261
- US-A- 5 573 877
- PATENT ABSTRACTS OF JAPAN vol. 1999, no. 12, 29 October 1999 (1999-10-29) & JP 11 194501 A (DAINIPPON PRINTING CO LTD), 21 July 1999 (1999-07-21)

## Description

### BACKGROUND OF THE INVENTION

### Field of the Invention

The present invention relates to clearance measuring devices and methods and, more specifically to a clearance measuring device and method used for adjusting a clearance between a photomask and a plate in an exposure apparatus.

### Description of the Background Art

Recently, a method of transferring a pattern on a photomask onto a plate by exposure while ensuring a small clearance between the photomask and the plate has been widely used. Such an exposure method is called an off contact exposure method or proximity exposure method.

In the off contact exposure method and proximity exposure method, a clearance between a photomask and a plate must be measured and adjusted by a highly reliable method. For example, the clearance between the photomask and the plate is generally adjusted to be from 0.05 mm to 0.5 mm.

Now, a conventional method of measuring a clearance between a photomask and a plate, as for example disclosed in US-A-4 618 261, will be described with reference to Fig. 12. Shown in Fig. 12 are a clearance measuring device 300 for measuring the clearance between the photomask and the plate, and plate 101 and photomask 102 spaced apart by a clearance G5.

Clearance measuring device 300 includes in a box 301: a laser light source 302 for diagonally and downwardly directing light 302a to plate 101 and photomask 102; and a light sensor 303 sensing the light reflected by plate 101 and photomask 102.

Light 302a is divided into light 302b reflected by a surface 102a of photomask 102 which is opposite to plate 101, and light 302c reflected by a surface 101a of plate 101 which is opposite to photomask 102. Light 302b and 302c are sensed by light sensor 303, and a distance S5 between light 302b and 302c is calculated by a processor (not shown).

Here, as distance S5 is proportional to clearance G5, clearance G5 can be preliminary adjusted to provide a given distance S5.

However, conventional clearance measuring device 300 is expensive. If a plurality of clearance measuring devices 300 must be provided to measure the clearance between plate 101 and photomask 102 at a plurality of locations, the problem associated with a cost arises.

Further, conventional clearance measuring device 300 requires a processor in addition to the device used for aligning photomask 102 and plate 101. As a result, the problem associated with the cost arises and the structure of the clearance measuring device becomes complicated.

Moreover, conventional clearance measuring device 300 requires laser light source 302 and light sensor 303 in addition to these at used for aligning photomask 102 and plate 101. Thus, the structure of the clearance measuring device becomes complicated.

When the pattern on photomask 102 is transferred onto plate 101 by exposure, a mechanism for moving clearance measuring device 300 outside photomask 101 must be provided. Thus, the structure of the clearance measuring device becomes complicated.

### SUMMARY OF THE INVENTION

An object of the present invention is to provide a clearance measuring device and method capable of accurately and inexpensively measuring a clearance between a plate and a photomask.

Another object of the present invention is to provide a clearance measuring device and method capable of easily and inexpensively measuring a clearance between a plate and a photomask when the clearance is to be measured at a plurality of locations.

According to the present invention, a clearance measuring device is provided which measures a clearance between a photomask and a plate for adjusting it to a prescribed value based on the measurement data in an exposure apparatus transferring a pattern on the photomask onto the plate by exposing the plate to light through the photomask. The photomask has a mark used for measuring a clearance (hereinafter referred to as a clearance measuring mark) in a prescribed position on a surface opposite to the plate. The clearance measuring device includes: at least one light sensor sensing an image of the clearance measuring mark on the plate or a shadow of the clearance measuring mark projected on the plate when light is directed to the clearance measuring mark and a region including the clearance measuring mark; a processor calculating the clearance between the photomask and the plate based on a relative positional relationship between the image or shadow of the clearance measuring mark on the plate and the clearance measuring mark; and a clearance adjusting device adjusting the clearance between the photomask and the plate to a prescribed value by relatively moving the photomask and the plate based on the calculation result obtained by the processor.

According to the present invention, a clearance measuring method of an exposure apparatus transferring a pattern on a photomask having a clearance measuring mark onto a plate by exposing the plate to light through the photomask is provided in which the clearance between the photomask and the plate is measured and adjusted to a prescribed value based on a measurement data. In the clearance measuring method, the clearance between the photomask and the plate is calculated based on a relative positional relationship between an image or shadow of the clearance measuring mark on the plate and the clearance measuring mark when the light is directed to a region including the clearance measuring mark, and the clearance between the photomask and the plate is adjusted to a prescribed value by relatively moving the photomask and the plate based on the calculation result.

According to the clearance measuring device and method, when light is directed to the region including the clearance measuring mark on the photomask, a prescribed clearance between the photomask and the plate ensures the image or shadow of the clearance measuring mark on the plate.

The relative positional relationship between the clearance measuring mark of the photomask and the image or shadow of the clearance measuring mark, for example, an amount of displacement thereof, changes in accordance with the clearance between the photomask and the plate. In other words, the displacement between the clearance measuring mark of the photomask and the image or shadow of the clearance measuring mark is proportional to the clearance between the photomask and the plate.

Thus, the clearance measuring mark on the photomask and the image or shadow of the clearance measuring mark are sensed by the light sensor, and an amount of displacement of the clearance measuring mark on the photomask and the image or the shadow of the clearance measuring mark or the like can be calculated by the processor performing for example an image process.

As a result, the clearance between the photomask and the plate can accurately be adjusted to a prescribed value by the clearance adjusting device based on the calculation result.

Further, to implement the clearance measuring device and method in a more preferred manner, the clearance between the photomask and the plate may accurately be adjusted to a prescribed value by the clearance adjusting device based on an amount of difference in shape between the clearance measuring mark and the image or shadow of the clearance measuring mark or the like.

Preferably, an alignment mark for aligning the photomask and the plate or a portion of the pattern on the photomask to be transferred onto the plate may be used as the clearance measuring mark. Thus, the clearance measuring device and method of the present invention are achieved without increasing the number of patterns to be formed on the photomask.

Preferably, the light sensor is used which is provided with a mechanism movable in X and Y directions of the photomask. Thus, the light sensor can move in X and Y directions of the photomask, so that the clearance between the plate and the photomask can readily be measured at a plurality of locations.

To implement the clearance measuring device and method in a more preferred manner, the light sensor may be provided with a mechanism capable of moving in a direction perpendicular to the surface of the photomask.

Further, to implement the clearance measuring device and method in the more preferred manner, a mechanism capable of adjusting an angle of the light sensor may be provided.

To implement the clearance measuring device and method in the more preferred manner, at least one mirror may be used for the light sensor for sensing the clearance measuring mark or the image or shadow of the clearance measuring mark by the light sensor.

Preferably, a processor for aligning the photomask and the plate is used as the above mentioned processor. Thus, a dedicated processor is not necessary and a mechanism of the clearance measuring device can be simplified.

The light sensor may be used for aligning the photomask and the plate. Thus, a dedicated light sensor is not necessary and the mechanism of the clearance measuring device can be simplified.

To implement the clearance measuring device and the method in the more preferred manner, at least one light irradiation device for irradiating the region including the clearance measuring mark with light may be provided.

The light irradiation device may be used for aligning the photomask and the plate. Thus, a dedicated light irradiation device is not necessary and the mechanism of the clearance device can be simplified.

To implement the clearance measuring device and method in the more preferred manner, for example, at least one mirror may be provided for the optical system as the light irradiation device.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic diagram showing a structure of a clearance measuring device 100A according to a first embodiment of the present invention.

Fig. 2 is a schematic diagram showing a structure of a clearance measuring device 200A according to a second embodiment of the present invention.

Figs. 3A and 3B are schematic diagrams respectively shown in conjunction with first clearance measuring methods using clearance measuring devices 100A and 200A of the first and second embodiments.

Fig. 4 is a view showing an alignment mark and a pattern P1 on a photomask 102 as well as X and Y directions of the photomask.

Fig. 5 is a schematic diagram showing a mechanism capable of moving in a direction (Z direction) perpendicular to the photomask and a mechanism capable of adjusting an angle with respect to the photomask (θ direction) provided in the CCD camera.

Fig. 6 is a schematic diagram showing a structure of a clearance measuring device according to another embodiment of the present invention.

Fig. 7 is a schematic diagram showing a structure of a clearance measuring device 100B according to a fourth embodiment of the present invention.

Figs. 8A and 8B are schematic diagrams shown in conjunction with a first clearance measuring method using clearance measuring device 100B according to the fourth embodiment.

Fig. 9 is a schematic diagram showing a structure of a clearance measuring device 100B according to a fifth embodiment.

Figs. 10A and 10B are schematic diagrams shown in conjunction with a first clearance measuring method using clearance measuring device 100B according to the fifth embodiment.

Figs. 11A and 11B are schematic diagrams shown in conjunction with a second clearance measuring method using clearance measuring device 200B according to the fifth embodiment.

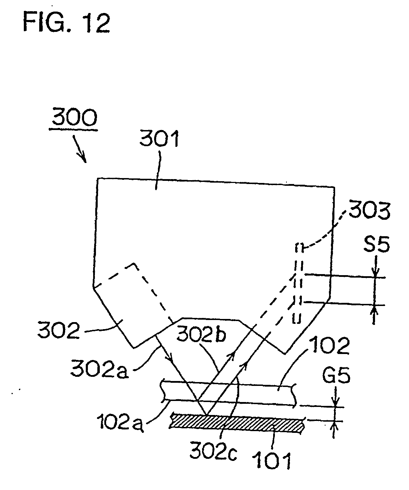

Fig. 12 is a diagram showing a clearance measuring device 300 of the conventional art for measuring a clearance between a photomask and a plate, as well as plate 101 and photomask 102 which are spaced by a clearance G5.

### DESCRIPTION OF THE PREFERRED EMBODIMENTS

Embodiments of the clearance measuring device and method of the present invention will now be described with reference to the drawings.

### First Embodiment

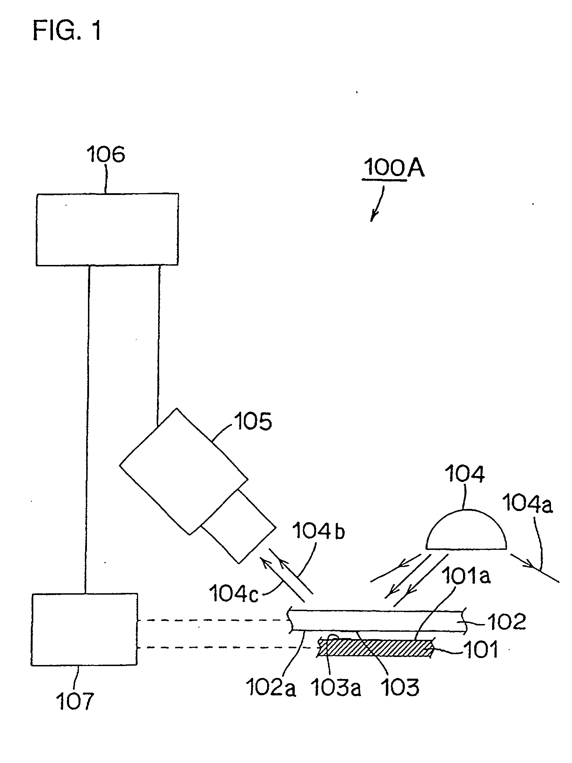

Fig. 1 is a schematic diagram showing a general structure of a clearance measuring device 100A of the first embodiment.

Referring to Fig. 1, a general structure of a clearance measuring device 100A of the present embodiment will be described. A photomask 102 is arranged above a plate 101 with a prescribed clearance. The clearance between plate 101 and photomark 102 can be adjusted by a clearance adjusting device 107. A clearance measuring mark 103 is formed on photomask 102 in a prescribed position on a surface 102a opposite to plate 101.

A light irradiation device 104 is arranged above photomask 102 for directing light to a region including clearance measuring mark 103.

Provided diagonally above photomask 102 is a CCD camera 105 as a light sensor sensing light 104b reflected by a surface 102a of photomask 102 opposite to plate 101 and a light 104c reflected by a surface 101a of plate 101 opposite to the photomask, which lights are both divided from light 104a directed from light irradiation device 104.

A processor 106 for performing an image process on an image pattern sensed by device CCD camera 105 for calculation is connected to CCD camera 105. Clearance adjusting device 107 is controlled based on the calculation result from processor 106.

### Second Embodiment

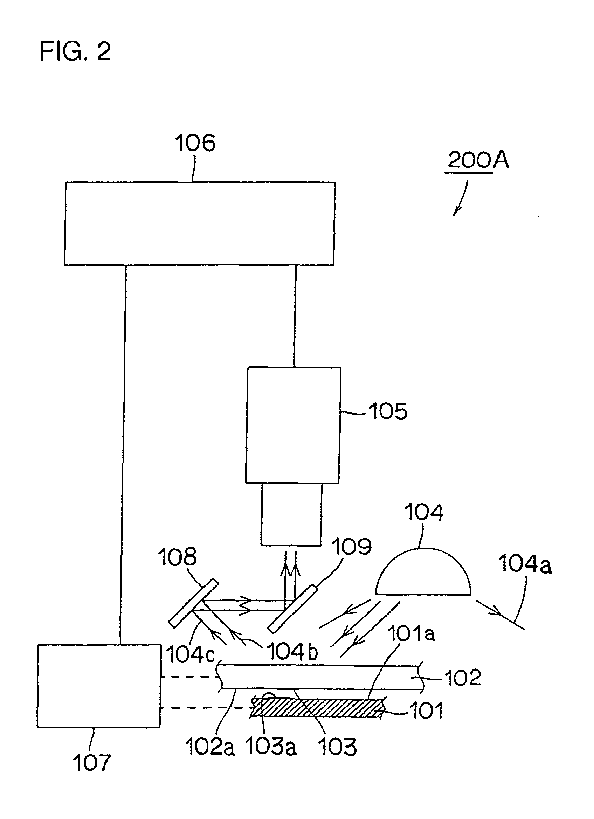

Referring to Fig. 2, a general structure of a clearance measuring device 200A of the present embodiment will be described. A photomask 102 is arranged above plate 101 with a prescribed clearance. The clearance between plate 101 and photomask 102 can be adjusted by a clearance adjusting device 107. A clearance measuring mark 103 is formed on photomask 102 in a prescribed position on a surface 102a which is opposite to plate 101.

Provided above photomask 102 is a light irradiation device 104 for irradiating a region including clearance measuring mark 103 with light.

Provided above photomask 102 is a CCD camera 105 as a light sensor sensing a light 104b reflected by a surface 102a of photomask 102 opposite to plate 101 and a light 104c reflected by a surface 101a of plate 101 opposite to the photomask, which lights are divided from light 104a directed from light irradiation device 104. Further, mirrors 108 and 109 are arranged above photomask 102 for directing lights 104b and 104c to CCD camera 105.

Thus, clearance measuring device 200 of the present embodiment differs from clearance measuring device 100 of the first embodiment in that mirrors 108 and 109 are arranged in an optical path of lights 104b and 104c directed to CCD camera 105.

A processor 106 for performing an image process on an image pattern sensed by CCD camera 105 for calculation is connected to CCD camera 105. Clearance adjusting device 107 is controlled based on the calculation result from processor 106.

### Third Embodiment

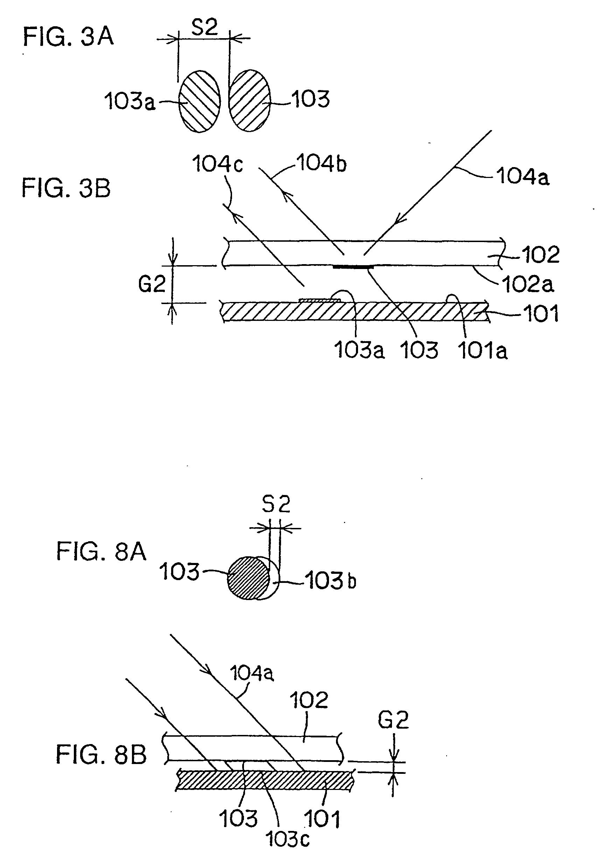

A clearance measuring method using clearance measuring devices 100A and 200A of the above described first and second embodiments will be described with reference to Figs. 3A and 3B. Figs. 3A and 3B relate to the case where the shape of clearance measuring mark 103 is circular.

Figs. 3A and 3B respectively show an image pattern sensed by CCD camera 105 and a longitudinal cross sectional view of plate 101 and photomask 102. Light 104a is directed to a region of photomask 102 including clearance measuring mark 103 by light irradiation device 104.

Light 104b reflected by surface 102a of photomask 102 opposite to plate 101 and light 104c reflected by surface 101a of plate 101 opposite to photomask 102 of light 104a are directed to CCD camera 105. Thus, clearance measuring mark 103 and an image 103a of the clearance measuring mark projected onto surface 101a of plate 101 opposite to photomask 102 are sensed as image patterns by CCD camera 105.

Referring to Figs. 3A and 3B, an amount of displacement of image 103a of the clearance measuring mark with respect to clearance measuring mark 103 changes in accordance with the clearance between photomask 102 and plate 101. In other words, the amount of displacement S1 of image 103a of the clearance measuring mark from clearance measuring mark 103 is proportional to the difference between photomask 102 and plate 101.

Clearance measuring mark 103 on photomask 102 and image 103a of the clearance measuring mark projected onto plate surface 101a are sensed as image patterns by CCD camera 105, so that the amount of displacement of image 103a of the clearance measuring mark from clearance measuring mark 103 can be calculated by processor 106 using an image process or the like.

Based on the calculated amount of displacement of image 103a from clearance measuring mark 103, the clearance between photomask 102 and plate 101 can be adjusted to a prescribed value by clearance adjusting device 107.

### Fourth Embodiment

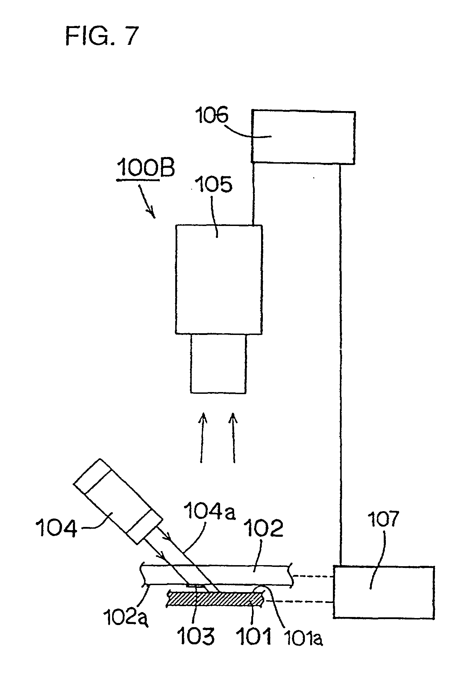

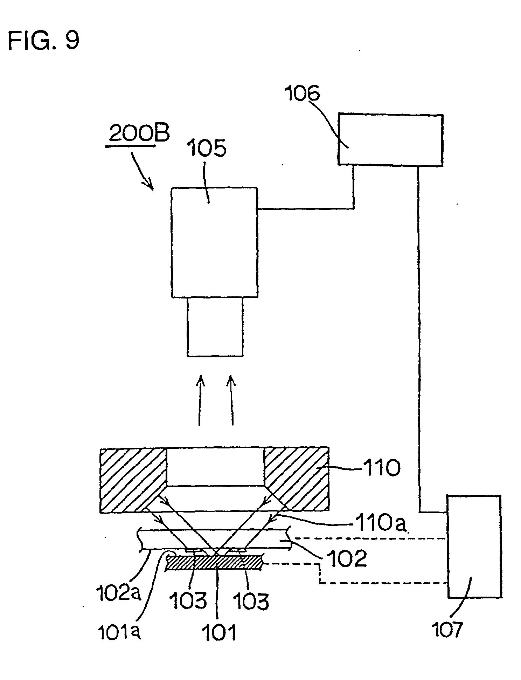

Referring to Figs. 7, 8A and 8B, a clearance measuring device and method of the fourth embodiment will be described.

First, referring to Fig. 7, a general structure of a clearance measuring device 100A of the present embodiment will be described. A photomask 102 is arranged above a plate 101 with a prescribed clearance. The clearance between plate 101 and photomask 102 can be adjusted by a clearance adjusting device 107. A clearance measuring mark 103 is formed in a prescribed position on surface 102a of photomask 102 which is opposite to plate 101.

Provided above photomask 102 is a light irradiation device 104 for diagonally and downwardly directing light to plate 101 in one direction.

Provided above photomask 102 is a CCD camera 105 as a light sensor sensing the light directed from light irradiation device 104 and reflected by photomask surface 102a and plate surface 101a which is opposite to the photomask.

CCD camera 105 is provided with a processor 106 for performing an image process on image data sensed from CCD camera 105 for calculation. Clearance adjusting device 107 is controlled based on the calculation result from processor 106.

Now, referring to Figs. 8A and 8B, a clearance measuring method using the above described clearance measuring device 100B will be described. Figs. 8A and 8B show the case where the shape of clearance measuring mark 103 is circular.

Figs. 8A and 8B respectively show an image pattern sensed by CCD camera 105 as well as a longitudinal cross sectional view of plate 101 and photomask 102. Light 104a is diagonally and downwardly directed to clearance measuring mark 103 on photomask 102 by light irradiation device 104. Clearance measuring mark 103 and a shadow 103b of clearance measuring mark 103, which is projected on plate surface 101a, are sensed as image patterns by CCD camera 105.

Referring to Figs. 8A and 8B, an amount of change in shadow 103b with respect to clearance measuring mark 103 changes in accordance with the clearance between photomask 102 and plate 101. In other words, an amount of displacement S2 of clearance measuring mark 103 and shadow 103b of the clearance measuring mark is proportional to a distance G2 between photomask 102 and plate 101.

Thus, clearance measuring mark 103 of photomask 102 and shadow 103b of the clearance measuring mark projected on plate surface 101a are sensed as image patterns by CCD camera 105 for performing an image process by processor 106, so that the amount of displacement of clearance measuring mark 103 and shadow 103b can be calculated.

In accordance with the amount of displacement of clearance measuring mark 103 and shadow 103b of clearance measuring mark, the clearance between photomask 102 and plate 101 can accurately be adjusted to a prescribed value by clearance adjusting device 107.

### Fifth Embodiment

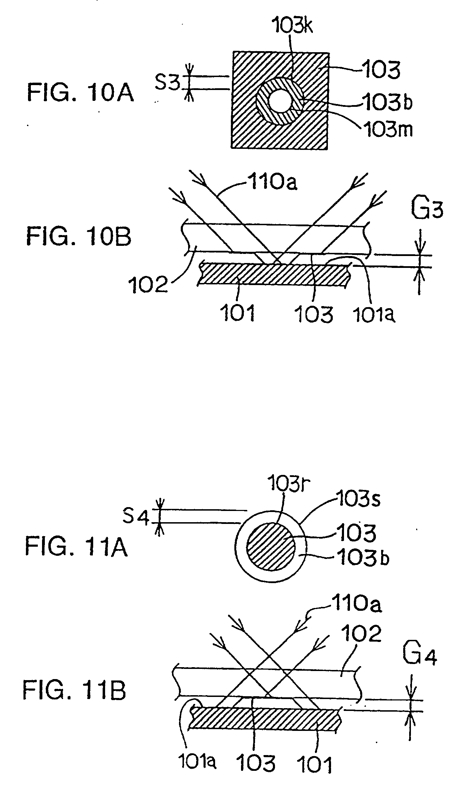

Now, referring to Figs. 9 to 11B, a clearance measuring device and method of the fifth embodiment will be described.

First, referring to Fig. 9, a general structure of clearance measuring device 200B of the present embodiment will be described. A photomask 102 is arranged above plate 101 with a prescribed clearance. The clearance between plate 101 and photomask 102 can be adjusted by a clearance adjusting device 107. A clearance measuring mark 103 is formed in a prescribed position on surface 102a of photomask 102 which is opposite to plate 101.

Provided above photomask 102 is a light irradiation device 110 in a ring like shape for diagonally and downwardly directing light to a region including clearance measuring mark 103 in all directions.

A CCD camera 105 is arranged above photomask 102 as a light sensor sensing the light directed from light irradiation device 110 and reflected by a surface 102a of photomask 102 which is opposite to plate 101 and a surface 101a of plate 101 which is opposite to the photomask.

CCD camera 105 is provided with a processor 106 for performing an image process on an image pattern obtained from CCD camera 105 for calculation. Clearance adjusting device 107 is controlled based on the calculation result from processor 106.

Next, a clearance measuring method using the above described clearance measuring device 200B will be described with reference to Figs. 10A, 10B, 11A and 11B. Figs. 10A and 10B relate to the case where the shape of clearance measuring mark 103 is circular when viewed from above and has a circular portion inside. Figs. 11A and 11B relate to the case where the shape of clearance measuring mark 103 is circular when viewed from above and does not have a circular portion inside.

Figs. 10A and 10B respectively shows an image pattern sensed by CCD camera 105 as well as a longitudinal cross sectional view of plate 101 and a photomask 102. Light 110a is diagonally and downwardly directed to clearance measuring mark 103 on photomask 102 in all directions by light irradiation device 110.

Clearance measuring mark 103 and shadow 103b of clearance measuring mark, which is an image of clearance measuring mark 103 projected onto plate 101, are sensed as image patterns by CCD camera 105. Further, an outer portion 103k in a ring like shape of clearance measuring mark 103 and an inner circle 103m of shadow 103b of clearance measuring mark, which is an image defined by outer portion 103k, are sensed as image patterns by CCD camera 105.

An amount of change in shape of inner circle 103m projected on plate 101 from outer portion 103k changes in accordance with the clearance between photomask 102 and plate 101. In other words, a difference in shape S3 between outer portion 103k and inner circle 103m is proportional to clearance G3 between photomask 102 and plate 101.

Thus, the amount of change of inner circle 103m from outer portion 103k is sensed as image data by CCD camera for an image process by processor 106, so that the difference between outer portion 103k and inner circle 103m can be calculated.

The clearance between photomask 102 and plate 101 can accurately be adjusted to a prescribed value by clearance adjusting device 107 in accordance with the calculated difference between outer portion 103k and inner circle 103m.

It noted that the position and shape of outer portion 103k can preliminary be determined, so that the difference between outer portion 103k and inner circle 103m can be calculated only by measuring the position and shape of inner circle 103m.

Fig. 11A and 11B respectively show an image pattern sensed by CCD camera 105 as well as a longitudinal cross sectional view of plate 101 and photomask 102. Light 110a is diagonally and downwardly directed to clearance measuring mark 103 on photomask 102 in all directions by light irradiation device 110.

Clearance measuring mark 103 and shadow 103b of clearance measuring mark, which is an image of clearance measuring mark 103, are sensed by CCD camera 105 as image patterns. Further, outer portion 103r of clearance measuring mark 103 and an outer portion 103s of shadow 103b of clearance measuring mark which is an image defined by outer portion 103r are sensed as image patterns by CCD camera 105.

An amount of difference between portion 103r of clearance measuring mark 103 and outer portion 103s of shadow 103b of clearance measuring mark changes in accordance with the clearance between photomask 102 and plate 101. In other words, a difference S4 between portion 103r of clearance measuring mark 103 and outer portion 103s of shadow 103b is proportional to clearance G4 between photomask 102 and plate 101.

Thus, portion 103r of clearance measuring mark 103 and outer portion 103s of shadow 103b are sensed as image data by CCD camera 105 for an image process by processor 106, so that the difference between portion 103r of clearance measuring mark 103 and outer portion 103s of shadow 103b can be calculated.

Based on the calculated amount of change in shape of outer portion 103s from portion 103r, the clearance between photomask 102 and plate 101 can accurately be adjusted to a prescribed value by clearance adjusting device 107.

It is noted that the shape of portion 103r of clearance measuring mark 103 can preliminary be determined, so that the difference between portion 103r of clearance measuring mark 103 and outer portion 103s of shadow 103b can be calculated only by measuring the position of outer portion 103s of shadow 103b.

In the clearance measuring device and method of the above described embodiment, if there is a prescribed clearance between photomask 102 and plate 101, image 103a or shadow 103b of the clearance measuring mark is projected onto plate surface 101a.

The relative positional relationship between clearance measuring mark 103 on photomask 102 and image 103a or shadow 103b changes in accordance with the clearance between the photomask 102 and plate 101. In other words, the relative positional relationship between clearance measuring mark 103 on photomask 102 and image 103a or shadow 103b is proportional to the clearance between the photomask and the plate.

Accordingly, clearance measuring mark 103 on photomask 102 and image 103a reflected by plate surface 101a or shadow 103b projected on plate surface 101a are sensed by a light sensor, i.e., CCD camera 105, so that the relative positional relationship between clearance measuring mark 103 on photomask 102 and image 103a or shadow 103b can be calculated by the processor such as an image processor.

The clearance between photomask 102 and plate 101 can be accurately adjusted to a prescribed value by clearance adjusting device 106 based on the calculation result.

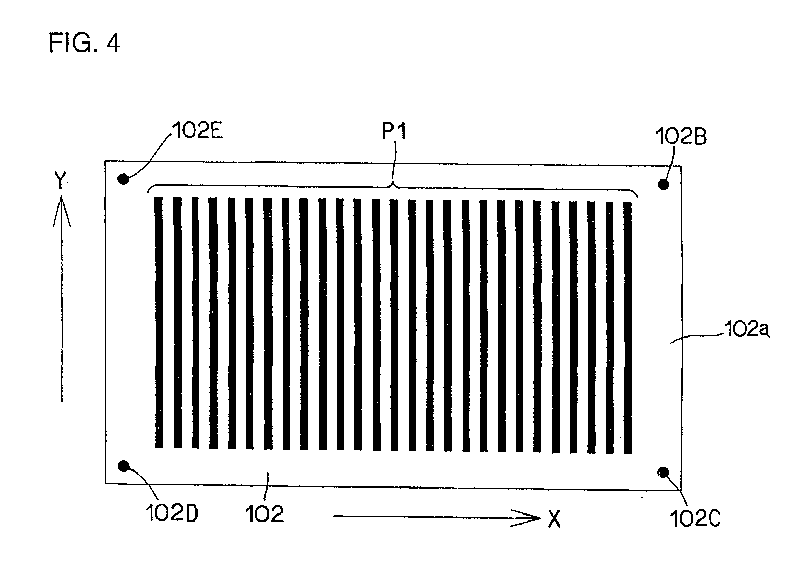

It is noted that, in each of the above described embodiments, alignment marks (102B, 102C, 102D, 102E) used for aligning photomask 102 and plate 101 can be used as clearance measuring mark 103 as shown in Fig. 4. Conversely, clearance measuring mark 103 may be used as an alignment mark for aligning photomask 102 and plate 101. Thus, the clearance measuring device and method of each of the embodiments can be achieved without increasing the number of patterns to be formed on photomask 102.

Further, as shown in Fig. 4, a portion of a pattern P1 on photomask 102 which is to be transferred onto plate 101 may be used as clearance measuring mark 103. Thus, the clearance measuring device and method of each of the embodiments can be implemented without increasing the number of patterns to be formed on photomask 102.

In the above described first to third embodiments, the amount of displacement of image 103a from clearance measuring mark 103 is used as the relative positional relationship between clearance measuring mark 103 and image 103a. However, an amount of change in shape of image 103a from clearance measuring mark 103 may be used.

In each of the above described embodiments, preferably, CCD camera 105 is provided with a mechanism capable of moving in X and Y directions (Fig. 4) on photomask surface 102a. Thus, the clearance between plate 101 and photomask 102 can readily be measured at a plurality of locations.

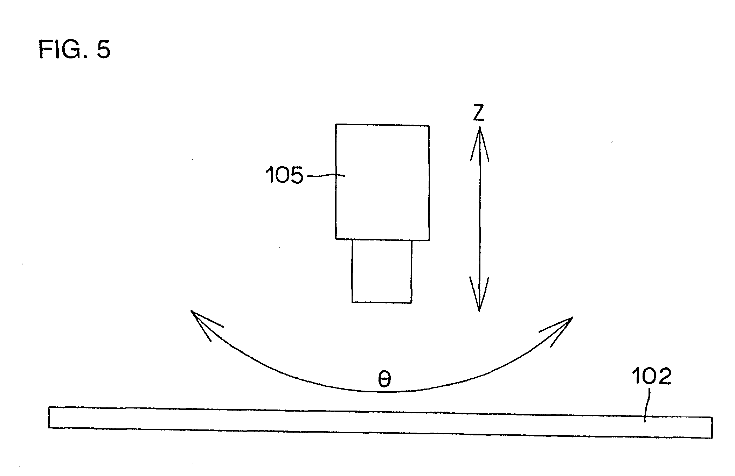

Preferably, CCD camera 105 is provided with a mechanism capable of moving in a direction perpendicular to photomask surface 102a (Fig. 5, Z direction). More preferably, a mechanism capable of adjusting an angle with respect to photomask surface 102a (Fig. 5, θ direction) is provided. Thus, CCD camera used for aligning photomask 102 and plate 101 can be used as a light sensor sensing both light 104b and 104c, so that a dedicated CCD camera for sensing light 104b and 104c is not necessary. As a result, the mechanism of the clearance measuring device can be simplified.

Processor 106 may change and use a program for aligning photomask 102 and plate 101 in order to calculate the relative relationship between clearance measuring mark 103 and image 103a or shadow 103b. Thus, a dedicated processor is not necessary and the mechanism of the clearance measuring device can be simplified.

In each of the above described embodiments, one CCD camera 105 is provided as a light sensor for sensing clearance measuring mark 103 and image 103a or shadow 103b of clearance measuring mark 103. However, two CCD cameras may be provided for clearance measuring mark 103 and image 103a or shadow 103b of clearance measuring mark 103, respectively.

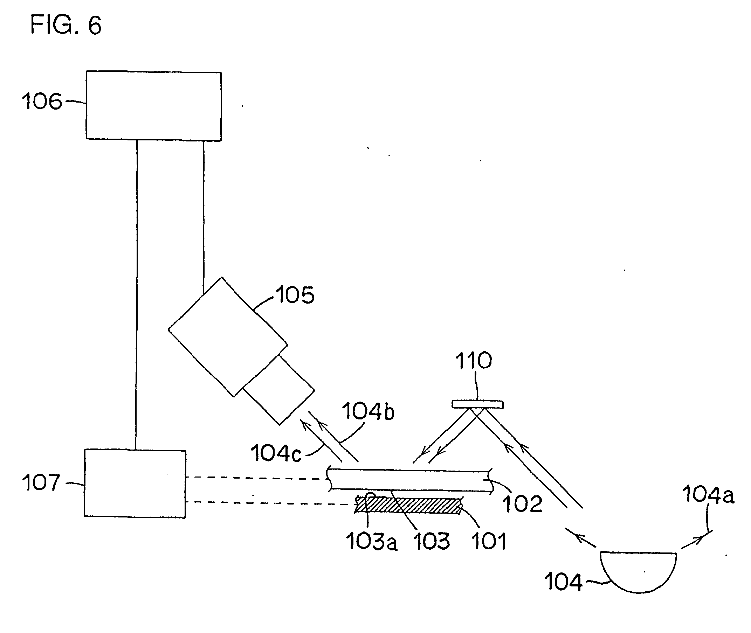

In each of the above described embodiments, light irradiation device 104 is provided on the same side as CCD camera 105 (on the side opposite to that on which plate 101 is arranged when viewed from photomask 102). However, as shown in Fig. 6, it may be provided on the side opposite to that on which CCD camera is 105 is provided (on the side plate 101 is arranged when viewed from photomask 102).

In addition, a light source directing light with a long wavelength of at least that of yellow light may be used as light irradiation device 104, or a laser beam may be used as the light source. Thus, the transfer of the pattern on photomask 102 onto the plate by light irradiation is not affected.

A light irradiation device used for aligning photomask 102 and plate 101 is also used as light irradiation device 104. Thus, a dedicated light irradiation device is not necessary and a mechanism of the clearance measuring device can be simplified.

It is noted that, in each of the above described embodiments, light irradiation device 104 is provided for clearly projecting image 103a or shadow 103b of clearance measuring mark 103 on photomask 102 onto plate surface 101a. If, for example, image 103a or shadow 103b of the clearance measuring mark is sufficiently clearly projected onto plate surface 101a by an existing light at the place where clearance measuring device 100 is provided, light irradiation device 104 is not necessarily required. Thus, a mechanism of the clearance measuring device can be simplified.

In addition, although the CCD camera is used as a light sensor in the above described embodiments, a light sensor having a similar function may be used.

According to the clearance measuring device and method of the present invention, when the region including the clearance measuring mark of the photomask is irradiated with light, if there is a prescribed clearance between the photomask and the plate, the image or shadow of the mark is projected on the plate surface.

The amount of displacement or change in shape of the image or shadow of the clearance measuring mark changes in accordance with a clearance between the photomask and the plate based on a relative relationship between the image or shadow and the mark on the photomask. In other words, the amount of displacement or change in shape of the image or shadow of the clearance measuring mark is proportional to the clearance between the photomask and the plate.

Therefore, the clearance measuring mark and the image or shadow of the mark are sensed by the light sensor, and the amount of displacement or change of the clearance measuring mark of the photomask and the image or shadow of the clearance measuring mark are calculated by a processor performing for example an image process.

Based on the calculation result, the clearance between the photomask and the plate can accurately be adjusted to a prescribed value by a clearance adjusting device.

Although the present invention has been described and illustrated in detail, it is clearly understood that the same is by way of illustration and example only and is not to be taken by way of limitation, the present invention being limited only by the terms of the appended claims.

## Claims

1. A clearance measuring device (100A, 200A) measuring a clearance between a photomask (102) and a plate (101) for adjusting said clearance between said photomask (102) and said plate (101) to a prescribed value in accordance with the measurement data in an exposure apparatus transferring a pattern on said photomask (102) onto said plate (101) by directing light to said plate (101) through said photomask (102), said photomask (102) having a clearance measuring mark (103) in a prescribed position on a surface opposite to said plate (101), comprising:
at least one light sensor (105) for sensing an image (103a) or shadow (103b) of said clearance measuring mark projected on said plate (101) by irradiating said clearance measuring mark (103) and a region including said clearance measuring mark (103) with light;
calculating means (106) calculating a clearance between said photomask (102) and said plate (101) based on a relative positional relationship between said clearance measuring mark (103) and said image (103a) or said shadow (103b) of said clearance measuring mark (103); and
clearance adjusting means (107) for adjusting the clearance between said photomask (102) and said plate (101) to a prescribed value by relatively moving said photomask (102) and said plate (101) based on the calculation result from said calculating means (106).

2. The clearance measuring device according to claim 1, wherein an alignment mark (102B, 102C, 102D, 102E) used for aligning said photomask (102) and said plate (101) is used as said clearance measuring mark (103), or a
portion of said pattern (P3) on said photomask (102) to be transferred onto said plate (101) is used as said clearance measuring mark (103).

3. The clearance measuring device according to claim 1 or 2, wherein said light sensor (105) is provided with a mechanism movable in X and Y directions of said photomask (102), or provided with a mechanism movable in a direction prependicular to a surface of said photomask (102), or provided with a mechanism capable of adjusting an angle with respect to the surface of said photomask (102).

4. The clearance measuring device according to one of claims 1 to 3, further comprising at least one mirror (108, 109) in an optical system for sensing said clearance measuring mark and said image or shadow of said clearance measuring mark by said light sensor (105).

5. The clearance measuring device according to one of claims 1 to 4, wherein a processor or a CCD camera for aligning said photomask (102) and said plate (102) is used as said light sensor (105).

6. The clearance measuring device according to one of claims 1 to 5, further comprising at least one light irradiation means (104) for irradiating said region including said clearance measuring mark (103) with light.

7. The clearance measuring device according to claim 6, wherein light irradiation means for aligning said photomask and said plate is used as said light irradiation means (104).

8. The clearance measuring device according to claim 6 or 7, wherein said light irradiation means (104) has at least one mirror (110) in an optical system.

9. A clearance measuring method using a photomask having a clearance measuring mark (103) for measuring a clearance between said photomask (102) and a plate (101) and adjusting said clearance between said photomask (102) and said plate (101) to a prescribed value in an exposure apparatus directing a light to said plate (101) through said photomask (102) for transferring a pattern on said photomask (101) onto said plate (101), wherein said clearance between said photomask (102) and said plate (101) is calculated based on a relative positional relationship between an image (103a) or shadow (103b) of said clearance measuring mark projected onto said plate (101) and said clearance measuring mark (103) by irradiating a region including said clearance measuring mark (103) with light, and said photomask (102) and said plate (101) are relatively moved based on the calculation result, so that said clearance between said photomask (102) and said plate (101) is adjusted to a prescribed value.

10. The clearance measuring method according to claim 9, wherein said light is directed from at least one light source to said region including said clearance measuring mark (103).

## Patentansprüche

1. Freiraummeßvorrichtung (100A, 200A), die einen Freiraum zwischen einer Photomaske (102) und einer Platte (101) mißt, zum Einstellen des Freiraumes zwischen der Photomaske (102) und der Platte (101) auf einen vorgeschriebenen Wert gemäß der Meßdaten in einem Belichtungsgerät, das ein Muster auf der Photomaske (102) auf die Platte (101) durch Richten von Licht durch die Photomaske (102) auf die Platte (101) überträgt, wobei die Photomaske (102) eine Freiraummeßmarke (103) an einer vorgeschriebenen Position auf einer Oberfläche gegenüber der Platte (101) aufweist, mit:
mindestens einem Lichtsensor (105) zum Erfassen eines Bildes (103a) oder eines Schattens (103b) der Freiraummeßmarke, die auf die Platte (101) durch Bestrahlen der Freiraummeßmarke (103) und
eines die Freiraummeßmarke (103) enthaltenden Bereiches mit Licht projiziert werden;
einem Berechnungsmittel (106), das einen Freiraum zwischen der Photomaske (102) und der Platte (101) berechnet auf der Grundlage der Relativpositionsbeziehung zwischen der Freiraummeßmarke (103) und dem Bild (103a) oder dem Schatten (103b) der Freiraummeßmarke (103); und
einem Freiraumeinstellmittel (107) zum Einstellen des Freiraumes zwischen der Photomaske (102) und der Platte (103) auf einen vorgeschriebenen Wert durch relatives Bewegen der Photomaske (102) und der Platte (101) auf der Grundlage des Berechnungsresultates von dem Berechnungsmittel (106).

2. Freiraummeßvorrichtung nach Anspruch 1, bei der eine Ausrichtungsmarke (102B, 102C, 102D, 102E), die zum Ausrichten der Photomaske (102) und der Platte (101) benutzt wird, als die Freiraummeßmarke (103) benutzt wird, oder ein Abschnitt des Musters (P3) auf der Photomaske (102), das auf die Platte (101) zu übertragen ist, als die Freiraummeßmarke (103) benutzt wird.

3. Freiraummeßvorrichtung nach Anspruch 1 oder 2, bei der der Lichtsensor (105) mit einem in eine X- und eine Y-Richtung der Photomaske (102) bewegbaren Mechanismus versehen ist oder mit einem in eine Richtung senkrecht zu einer Oberfläche der Photomaske (102) bewegbaren Mechanismus versehen ist oder mit einem Mechanismus, der einen Winkel in Bezug auf die Oberfläche der Photomaske (102) einstellen kann, versehen ist.

4. Freiraummeßvorrichtung nach einem der Ansprüche 1 bis 3, weiter mit mindestens einem Spiegel (108, 109) in einem optischen System zum Erfassen der Freiraummeßmarke und des Bildes oder des Schattens der Freiraummeßmarke durch den Lichtsensor (105).

5. Freiraummeßvorrichtung nach einem der Ansprüche 1 bis 4, bei der ein Prozessor oder eine CCD-Kamera zum Ausrichten der Photomaske (102) und der Platte (101) als der Lichtsensor (105) benutzt wird.

6. Freiraummeßvorrichtung nach einem der Ansprüche 1 bis 5, weiter mit einem Lichtstrahlmittel (104) zum Bestrahlen des die Freiraummeßmarke (103) enthaltenden Bereiches mit Licht.

7. Freiraummeßvorrichtung nach Anspruch 6, bei der das Lichtstrahlmittel zum Ausrichten der Photomaske und der Platte als das Lichtstrahlmittel (104) benutzt wird.

8. Freiraummeßvorrichtung nach Anspruch 6 oder 7, bei der das Lichtstrahlmittel (104) mindestens einen Spiegel (110) in einem optischen System aufweist.

9. Freiraummeßverfahren, das eine Photomaske mit einer Freiraummeßmarke (103) benutzt, zum Messen eines Freiraumes zwischen der Photomaske (102) und einer Platte (101) und Einstellen des Freiraumes zwischen der Photomaske (102) und der Platte (101) auf einen vorgeschriebenen Wert in einem Belichtungsgerät, das Licht auf die Platte (101) durch die Photomaske (102) richtet zum Übertragen eines Musters auch der Photomaske (102) auf die Platte (101), worin der Freiraum zwischen der Photomaske (102) und der Platte (101) berechnet wird auf der Grundlage einer Relativpositionsbeziehung zwischen einem Bild (103a) oder einem Schatten (103b) der auf die Platte (101) projizierten Freiraummeßmarke und der Freiraummeßmarke (103) durch Bestrahlen eines die Freiraummeßmarke (103) enthaltenden Bereiches mit Licht, und worin die Photomaske (102) und die Platte 8101) relativ auf der Grundlage des Berechnungsresultates bewegt werden, so daß der Freiraum zwischen der Photomaske (102) und der Platte (101) auf einen vorgeschriebenen Wert eingestellt werden.

10. Freiraummeßverfahren nach Anspruch 9, bei dem das Licht von mindestens einer Lichtquelle auf den die Freiraummeßmarke (103) enthaltenden Bereiches gerichtet wird.

## Revendications

1. Dispositif de mesure d'espacement (100A, 200A) mesurant un espacement entre un photomasque (102) et une plaque (101) pour ajuster ledit espacement entre ledit photomasque (102) et ladite plaque (101) à une valeur prescrite en conformité avec les données de mesure dans un appareil d'exposition transférant un motif sur ledit photomasque (102) sur ladite plaque (101) en dirigeant la lumière vers ladite plaque (101) à travers ledit photomasque (102), ledit photomasque (102) comportant un repère de mesure d'espacement (103) à une position prescrite sur une surface opposée à ladite plaque (101), comprenant :
au moins un capteur de lumière (105) pour détecter une image (103a) ou une ombre (103b) dudit repère de mesure d'espacement projetée sur ladite plaque (101) en irradiant ledit repère de mesure d'espacement (103) et une région incluant ledit repère de mesure d'espacement (103) avec la lumière ;
un moyen de calcul (106) calculant un espacement entre ledit photomasque (102) et ladite plaque (101) sur la base d'une relation de position relative entre ledit repère de mesure d'espacement (103) et ladite image (103a) ou ladite ombre (103b) dudit repère de mesure d'espacement (103) ; et
un moyen d'ajustement d'espacement (107) pour ajuster l'espacement entre ledit photomasque (102) et ladite plaque (101) à une valeur prescrite en déplaçant relativement ledit photomasque (102) et ladite plaque (101) sur la base du résultat du calcul provenant dudit moyen de calcul (106).

2. Dispositif de mesure d'espacement selon la revendication 1, dans lequel un repère d'alignement (102B, 102C, 102D, 102E) utilisé pour aligner ledit photomasque (102) et ladite plaque (101) est utilisé comme ledit repère de mesure d'espacement (103),
ou une partie dudit motif (P3) sur ledit photomasque (102) qui doit être transférée sur ladite plaque (101) est utilisée comme ledit repère de mesure d'espacement (103).

3. Dispositif de mesure d'espacement selon la revendication 1 ou 2, dans lequel ledit capteur de lumière (105) est pourvu d'un mécanisme déplaçable dans les directions X et Y dudit photomasque (102), ou pourvu d'un mécanisme déplaçable dans une direction perpendiculaire à une surface dudit photomasque (102), ou pourvu d'un mécanisme capable d'ajuster un angle par rapport à la surface dudit photomasque (102).

4. Dispositif de mesure d'espacement selon l'une quelconque des revendications 1 à 3, comprenant, en outre, au moins un miroir (108, 109) dans un système optique pour détecter ledit repère de mesure d'espacement et ladite image ou ladite ombre dudit repère de mesure d'espacement par ledit capteur de lumière (105).

5. Dispositif de mesure d'espacement selon l'une quelconque des revendications 1 à 4, dans lequel un processeur ou une caméra CCD pour aligner ledit photomasque (102) et ladite plaque (101) est utilisé comme ledit capteur de lumière (105).

6. Dispositif de mesure d'espacement selon l'une quelconque des revendications 1 à 5, comprenant, en outre, au moins un moyen d'irradiation de lumière (104) pour irradier ladite région incluant ledit repère de mesure d'espacement (103) avec la lumière.

7. Dispositif de mesure d'espacement selon la revendication 6, dans lequel le moyen d'irradiation de lumière pour aligner ledit photomasque et ladite plaque est utilisé comme ledit moyen d'irradiation de lumière (104).

8. Dispositif de mesure d'espacement selon la revendication 6 ou 7, dans lequel ledit moyen d'irradiation de lumière (104) comporte au moins un miroir (110) dans un système optique.

9. Procédé de mesure d'espacement utilisant un photomasque ayant un repère de mesure d'espacement (103) pour mesurer un espacement entre ledit photomasque (102) et une plaque (101) et ajuster ledit espacement entre ledit photomasque (102) et ladite plaque (101) à une valeur prescrite dans un appareil d'exposition dirigeant une lumière vers ladite plaque (101) à travers ledit photomasque (102) pour transférer un motif sur ledit photomasque (102) sur ladite plaque (101), dans lequel ledit espacement entre ledit photomasque (102) et ladite plaque (101) est calculé sur la base de la relation de position relative entre une image (103a) ou une ombre (103b) dudit repère de mesure d'espacement projeté sur ladite plaque (101) et ledit repère de mesure d'espacement (103) en irradiant une région incluant ledit repère de mesure d'espacement (103) avec la lumière, et ledit photomasque (102) et ladite plaque (101) sont déplacés relativement sur la base du résultat du calcul, de sorte que ledit espacement entre ledit photomasque (102) et ladite plaque (101) est ajusté à une valeur prescrite.

10. Procédé de mesure d'espacement selon la revendication 9, dans lequel ladite lumière est dirigée depuis au moins une source de lumière vers ladite région incluant ledit repère de mesure d'espacement (103).
